# EUROPEAN PATENT APPLICATION

(11) **EP 4 841 634 A1**
(43) Date of publication of application: **18.11.2026**
(21) Application number: 24925555.5
(22) Date of filing: 28.10.2024
(51) Int. Cl.: G11C 11/4063

(54) **SEMICONDUCTOR DEVICE AND DESIGN METHOD THEREFOR, AND ELECTRONIC DEVICE**

(30) Priority: 21.02.2024 CN 202410195023
(71) Applicant: Huawei Technologies Co., Ltd., Shenzhen, Guangdong 518129 (CN)
(72) Inventor: CUI, Changming, Shenzhen, Guangdong 518129 (CN); XU, Tuanhui, Shenzhen, Guangdong 518129 (CN); LI, Hao, Shenzhen, Guangdong 518129 (CN)
(74) Representative: Pfenning, Meinig & Partner mbB
(86) International application number: PCT/CN2024/127762
(87) International publication number: WO 2025/175817

(57) **Abstract**

Embodiments of this application provide a semiconductor device, a design method therefor, and an electronic device, and relate to the field of semiconductor technologies, to alleviate problems such as a low yield and low reliability of a chip. The semiconductor device includes a first die, a second die, and a plurality of interconnects. The first die includes a plurality of shift sending circuits, the second die includes a plurality of shift receiving circuits, and an i^{th} signal output end of the shift sending circuit is connected to an i^{th} signal input end of the shift receiving circuit through an i^{th} interconnect to form a shift transmission circuit. Any two adjacent interconnects of the semiconductor device are connected to different shift transmission circuits, and when a bridge fault occurs on the two adjacent interconnects, the different shift transmission circuits may separately perform shift repair on the interconnects.

## Description

This application claims priority to Chinese Patent Application No. 202410195023.6, filed with the China National Intellectual Property Administration on February 21, 2024 and entitled "SEMICONDUCTOR DEVICE, DESIGN METHOD THEREFOR, AND ELECTRONIC DEVICE", which is incorporated herein by reference in its entirety.

### TECHNICAL FIELD

Embodiments of this application relate to the field of semiconductor technologies, and in particular, to a semiconductor device, a design method therefor, and an electronic device.

### BACKGROUND

A three-dimensional integrated circuit (three-dimensional integrated circuit, 3D IC) interconnects a plurality of stacked dies in a vertical direction by using an interconnect like a through silicon via, and has advantages such as high performance, high bandwidth, low power consumption, and support for heterogeneous integration.

A 3D chip is prone to defects during manufacturing. For example, interconnect defects may be caused by factors such as misalignment-induced stress or external force, resulting in interconnect faults such as open faults, short faults, or bridge faults. These interconnect faults may be repaired through signal shifting or signal switching, and may affect the yield and reliability of the 3D chip.

### SUMMARY

Embodiments of this application provide a semiconductor device, a design method therefor, and an electronic device, to alleviate problems such as a low yield and low reliability of a chip.

According to a first aspect, an embodiment of this application provides a semiconductor device, including a first die, a second die, and a plurality of interconnects. The first die includes a plurality of signal sending nodes and a plurality of shift sending circuits, the shift sending circuit includes a plurality of signal input ends and a plurality of signal output ends, a signal input at an i^{th} signal input end is configured to be output from an i^{th} signal output end or an (i+1)^{th} signal output end, i is a positive integer, and the plurality of signal input ends of the shift sending circuit are separately connected to one signal sending node; the second die includes a plurality of signal receiving nodes and a plurality of shift receiving circuits, the shift receiving circuit includes a plurality of signal input ends and a plurality of signal output ends, an i^{th} signal output end is configured to output a signal input at an i^{th} signal input end or an (i+1)^{th} signal input end, and the plurality of signal output ends of the shift receiving circuit are separately connected to one signal receiving node; the i^{th} signal output end of the shift sending circuit is connected to the i^{th} signal input end of the shift receiving circuit through an i^{th} interconnect; and any two adjacent interconnects of the semiconductor device are connected to different shift sending circuits, and the two adjacent interconnects are connected to different shift receiving circuits.

The semiconductor device provided in this embodiment of this application includes a plurality of interconnects, and any two adjacent interconnects are located in different shift transmission circuits. When a bridge fault occurs on the adjacent interconnects, the bridge fault of the two interconnects may be converted into a fault of a single interconnect in two shift transmission circuits, and shift repair of the single interconnect may be implemented in the two shift transmission circuits, to implement bridge fault repair of the two interconnects.

In a possible implementation, different shift sending circuits have a same quantity of signal input ends or different quantities of signal input ends.

In a possible implementation, the shift sending circuit includes n signal input ends, n+1 signal output ends, and n-1 multiplexers, and the multiplexer includes a first input end, a second input end, and an output end. In the shift sending circuit, a first input end of an m^{th} multiplexer is connected to an m^{th} signal input end of the shift sending circuit, a second input end of the m^{th} multiplexer is connected to an (m+1)^{th} signal input end of the shift sending circuit, and an output end of the m^{th} multiplexer is connected to an (m+1)^{th} signal output end of the shift sending circuit, where m and n are positive integers, and m≤n-1.

In a possible implementation, a 1^{st} signal input end of the shift sending circuit is further connected to a 1^{st} signal output end of the shift sending circuit; and an n^{th} signal input end of the shift sending circuit is further connected to an (n+1)^{th} signal output end of the shift sending circuit.

In a possible implementation, different shift receiving circuits have a same quantity of signal input ends or different quantities of signal input ends.

In a possible implementation, the shift receiving circuit includes n+1 signal input ends, n signal output ends, and n multiplexers, and the multiplexer includes a first input end, a second input end, and an output end. In the shift receiving circuit, a first input end of an m^{th} multiplexer is connected to an m^{th} signal input end of the shift receiving circuit, a second input end of the m^{th} multiplexer is connected to an (m+1)^{th} signal input end of the shift receiving circuit, and an output end of the m^{th} multiplexer is connected to an m^{th} signal output end of the shift receiving circuit, where m and n are positive integers, and m≤n-1.

In a possible implementation, the plurality of interconnects are arranged in rows and columns, and any two adjacent interconnects in a same row or a same column are connected to different shift sending circuits and different shift receiving circuits.

In a possible implementation, the interconnect includes a micro bump, a hybrid bonding interconnect, and a through silicon via.

In a possible implementation, the plurality of interconnects include a first interconnect, a second interconnect, and a third interconnect, the first interconnect is adjacent to the second interconnect, a distance between the first interconnect and the second interconnect is less than or equal to a distance between the first interconnect and the third interconnect, and the distance between the first interconnect and the second interconnect is less than or equal to a distance between the second interconnect and the third interconnect.

According to a second aspect, an embodiment of this application provides a die, including a plurality of signal sending nodes, a plurality of shift sending circuits, and a plurality of interconnects. The shift sending circuit includes a plurality of signal input ends and a plurality of signal output ends, a signal input at an i^{th} signal input end is configured to be output from an i^{th} signal output end or an (i+1)^{th} signal output end, and i is a positive integer. The plurality of signal input ends of the shift sending circuit are separately connected to one signal sending node, and the plurality of signal output ends of the shift sending circuit are separately connected to one interconnect. Any two adjacent interconnects of the die are connected to different shift sending circuits.

In a possible implementation, different shift sending circuits have a same quantity of input ends or different quantities of input ends.

In a possible implementation, the shift sending circuit includes n signal input ends, n+1 signal output ends, and n-1 multiplexers, and the multiplexer includes a first input end, a second input end, and an output end. In the shift sending circuit, a first input end of an m^{th} multiplexer is connected to an m^{th} signal input end of the shift sending circuit, a second input end of the m^{th} multiplexer is connected to an (m+1)^{th} signal input end of the shift sending circuit, and an output end of the m^{th} multiplexer is connected to an (m+1)^{th} signal output end of the shift sending circuit, where m and n are positive integers, and m≤n-1.

In a possible implementation, a 1^{st} signal input end of the shift sending circuit is further connected to a 1^{st} signal output end of the shift sending circuit; and an n^{th} signal input end of the shift sending circuit is further connected to an (n+1)^{th} signal output end of the shift sending circuit.

According to a third aspect, an embodiment of this application further provides a die, including a plurality of signal receiving nodes, a plurality of shift receiving circuits, and a plurality of interconnects. The shift receiving circuit includes a plurality of signal input ends and a plurality of signal output ends, an i^{th} signal output end is configured to output a signal input at an i^{th} signal input end or an (i+1)^{th} signal input end, and i is a positive integer; the plurality of signal input ends of the shift receiving circuit are separately connected to one interconnect, and the plurality of signal output ends of the shift receiving circuit are separately connected to one signal receiving node. Any two adjacent interconnects of the die are connected to different shift receiving circuits.

In a possible implementation, different shift receiving circuits have a same quantity of signal input ends or different quantities of signal input ends.

In a possible implementation, the shift receiving circuit includes n+1 signal input ends, n signal output ends, and n multiplexers, and the multiplexer includes a first input end, a second input end, and an output end. In the shift receiving circuit, a first input end of an m^{th} multiplexer is connected to an m^{th} signal input end of the shift receiving circuit, a second input end of the m^{th} multiplexer is connected to an (m+1)^{th} signal input end of the shift receiving circuit, and an output end of the m^{th} multiplexer is connected to an m^{th} signal output end of the shift receiving circuit, where m and n are positive integers, and m≤n-1.

An embodiment of this application further provides a design method for a semiconductor device. The method includes: obtaining a target quantity of to-be-deployed shift transmission circuits, where the target quantity is greater than or equal to 2; and connecting a plurality of interconnects between a first die and a second die to a shift sending circuit of the first die and a shift receiving circuit of the second die, to form the target quantity of shift transmission circuits, where any two adjacent interconnects are located in different shift transmission circuits, the shift sending circuit includes a plurality of signal input ends and a plurality of signal output ends, a signal input at an i^{th} signal input end of the shift sending circuit is configured to be output from an i^{th} signal output end or an (i+1)^{th} signal output end of the shift sending circuit, the shift receiving circuit includes a plurality of signal input ends and a plurality of signal output ends, an i^{th} signal output end of the shift receiving circuit is configured to output a signal input at an i^{th} signal input end or an (i+1)^{th} signal input end of the shift receiving circuit, the i^{th} signal output end of the shift sending circuit is connected to the i^{th} signal input end of the shift receiving circuit through an i^{th} interconnect, and i is a positive integer.

In a possible implementation, the plurality of interconnects between the first die and the second die are arranged in an interconnect array with a plurality of rows and a plurality of columns, and connecting the plurality of interconnects between the first die and the second die to the shift sending circuit of the first die and the shift receiving circuit of the second die, to form the target quantity of shift transmission circuits, where any two adjacent interconnects are located in different shift transmission circuits includes: dividing the interconnect array into a plurality of interconnect groups in a diagonal direction of the interconnect array, where connection lines of interconnects in each interconnect group are parallel to each other; and connecting a plurality of interconnect groups spaced by j groups to a same shift transmission circuit, where j=k-1, and k is the target quantity of the to-be-deployed shift transmission circuits.

According to a fourth aspect, an embodiment of this application further provides a computer-readable storage medium. The computer-readable storage medium stores computer instructions, and when the computer instructions are executed, the steps of the method provided in any one of the third aspect and the implementations of the third aspect are implemented.

According to a fifth aspect, an embodiment of this application further provides a computer program product. When the computer program product runs on a processor, the processor is enabled to perform the steps of the method provided in any one of the third aspect and the implementations of the third aspect.

According to a sixth aspect, an embodiment of this application further provides a chip. The chip includes a substrate and the semiconductor device provided in any one of the first aspect and the implementations of the first aspect, and the semiconductor device is disposed on the substrate.

According to a seventh aspect, an embodiment of this application further provides an electronic device. The electronic device includes a circuit board and the chip provided in any one of the sixth aspect and the implementations of the sixth aspect, and the chip is electrically connected to the circuit board.

### BRIEF DESCRIPTION OF DRAWINGS

FIG. 1 is a diagram of a 3D chip according to an embodiment of this application;
FIG. 2 is a diagram of distribution of interconnects according to an embodiment of this application;
FIG. 3 is a diagram of a structure of a semiconductor device according to an embodiment of this application;
FIG. 4 is a diagram of a structure of another semiconductor device according to an embodiment of this application;
FIG. 5 is a diagram of signal-selection-based interconnect repair according to an embodiment of this application;
FIG. 6 is a diagram of a structure of another semiconductor device according to an embodiment of this application;
FIG. 7 is a diagram of signal-shifting-based interconnect repair according to an embodiment of this application;
FIG. 8 is a diagram of a signal-shifting repair solution according to an embodiment of this application;
FIG. 9 is a diagram of another signal-shifting repair solution according to an embodiment of this application;
FIG. 10 is a diagram of a structure of another semiconductor device according to an embodiment of this application;
FIG. 11 is another diagram of signal-shifting-based interconnect repair according to an embodiment of this application;
FIG. 12 is a diagram of a semiconductor device according to an embodiment of this application;
FIG. 13 is a diagram of another semiconductor device according to an embodiment of this application;
FIG. 14 is a diagram of another semiconductor device according to an embodiment of this application;
FIG. 15 is a diagram of a structure of another semiconductor device according to an embodiment of this application;
FIG. 16 is a diagram of distribution of interconnects according to an embodiment of this application;
FIG. 17 is a diagram of a deployment of shift transmission circuits according to an embodiment of this application;
FIG. 18 is a partial diagram of the deployment of the shift transmission circuits shown in FIG. 17;
FIG. 19 is a diagram of another deployment of shift transmission circuits according to an embodiment of this application;
FIG. 20 is a schematic flowchart of a design method for a semiconductor device according to an embodiment of this application; and
FIG. 21 is a diagram of grouping interconnects according to an embodiment of this application.

### DESCRIPTION OF EMBODIMENTS

The making and using of embodiments are described in detail below. However, it should be understood that many applicable inventive concepts provided in this application may be implemented in a plurality of specific environments. The specific embodiments described are merely used to describe specific manners of implementing and using this specification and this technology, and do not limit the scope of this application. Unless otherwise defined, all technical terms used in this specification have the same meanings as those commonly known to a person of ordinary skill in the art.

Circuits or other components may be described as or referred to as "used to" or "configured to" perform one or more tasks. In this case, the terms "used to" or "configured to" are used for implying a structure by indicating that a circuit/component includes a structure (for example, a circuit system) that performs one or more tasks during operation. Therefore, even when a specified circuit/component is currently not operable (for example, not turned on), the circuit/component may also be referred to as being configured to perform the task. Circuits/components used in conjunction with "configured to" include hardware, for example, a circuit for performing an operation.

The following describes the technical solutions in embodiments of this application with reference to the accompanying drawings in embodiments of this application. In this application, "at least one" means one or more, and "a plurality of" means two or more. The term "and/or" describes an association relationship between associated objects, and represents that three relationships may exist. For example, A and/or B may represent the following cases: Only A exists, both A and B exist, and only B exists, where A and B may be singular or plural. The character "/" generally indicates an "or" relationship between the associated objects. At least one of the following items (pieces) or a similar expression thereof indicates any combination of these items, including a single item (piece) or any combination of a plurality of items (pieces). For example, at least one of a, b, or c may indicate: a, b, c, a and b, a and c, b and c, or a, b, and c, where a, b, and c may be singular or plural.

In embodiments of this application, terms such as "first" and "second" are used to distinguish between objects with similar names or functions or effects. A person skilled in the art may understand that the terms such as "first" and "second" do not limit a quantity and an execution sequence. The term "coupling" is used for representing an electrical connection, including a direct connection through a wire or a connection end or an indirect connection through another component. Therefore, "coupling" should be considered as a generalized electronic communication connection.

It should be noted that in this application, the terms such as "example" or "for example" is used to represent giving an example, an illustration, or a description. Any embodiment or design scheme described as an "example" or "for example" in this application should not be explained as being more preferred or having more advantages than another embodiment or design scheme. To be precise, use of the terms such as "example" or "for example" is intended to present a related concept in a specific manner.

The integrated circuit industry has been developing rapidly by continuing the Moore's Law. The Moore's Law means that a quantity of transistors that can be accommodated on an integrated circuit doubles approximately every 18 to 24 months. However, with development of the Moore's Law, quantities of devices and transistors are increasing, and sizes of the devices and transistors are decreasing. As a result, a leakage current generated by an electronic tunnel effect becomes larger. From this perspective, the sizes of the transistors cannot be further reduced after being reduced to a specific size. Therefore, the development of the Moore's Law is limited and cannot continue indefinitely.

More than Moore (more than Moore) is a new development theory. When a size of a transistor or a chip is reduced to a specific extent, more functions may be integrated into a same chip or a same package by using an integrated stacking and packaging technology or the like, including packaging storage and computation together, and integrating an antenna, a sensor, and the like.

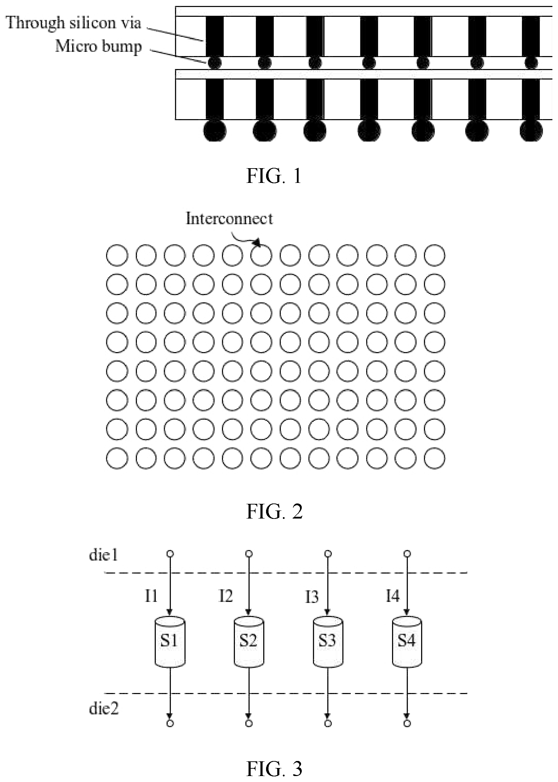

In recent years, 2.5D or 3D (3-dimensional, 3D) chips have become a key technical approach for implementing "more than Moore" in the industry. In these chips, a plurality of dies (dies) are interconnected through a passive interconnection component, or a plurality of active chips are vertically stacked in 3D. These dies or active chips are generally collectively referred to as chiplets (chiplets). Refer to FIG. 1. A 3D chip is used as an example. In the 3D chip, a plurality of homogeneous or heterogeneous wafers or circuit modules may be stacked in a vertical direction, and signal interconnection between dies may be implemented through an interconnect (or referred to as an interconnection medium) like a micro bump (micro bump), a hybrid bonding (hybrid bonding) interconnect, or a through silicon via (through silicon via, TSV). Refer to FIG. 2. FIG. 2 is a diagram of distribution of a plurality of interconnects. The plurality of interconnects between dies may be arranged in a form of matrix with a plurality of rows and a plurality of columns. These interconnects are characterized by high density and a small spacing, to satisfy requirements for an increase in an interconnection quantity and a bandwidth.

Refer to FIG. 3. In a simplified example, FIG. 3 is a diagram of a structure of a semiconductor device, including a first die die1 and a second die die2. The first die die1 is coupled to the second die die2 through a plurality of interconnects (for example, an interconnect S1 to an interconnect S4). The first die and the second die may transmit a signal through the interconnect, for example, transmit a signal I1 through the interconnect S1, transmit a signal I2 through the interconnect S2, transmit a signal I3 through the interconnect S3, and transmit a signal I4 through the interconnect S4.

In a current 3D stacked chip, the chip usually has a large quantity of interconnects, ranging from hundreds, thousands, or even tens of thousands. In consideration of test quality, a yield, and costs, testing and repairing of these interconnects are particularly important. Due to increasing density and a decreasing spacing between the interconnects, a probability that a short (short) or bridge (bridge) fault occurs between the interconnects becomes higher. If the interconnect is faulty, signal transmission between dies may be affected, and product quality is affected.

To repair a fault that occurs on the interconnect, for example, repair a short (short) fault, a bridge (bridge) fault, or the like, different vendors or standards provide different solutions, for example, a signal-switching (signal-switching)-based interconnect repair solution or a signal-shifting (signal-shifting)-based interconnect repair solution.

In the signal-switching-based interconnect repair solution, a redundant interconnect may be set. For example, one redundant interconnect is set for a group of interconnects. When an interconnect is faulty, the redundant interconnect may replace the faulty interconnect to transmit a signal. In actual application, a multiplexer may select to switch to the redundant interconnect to transmit a signal of the faulty interconnect, to complete fault repair.

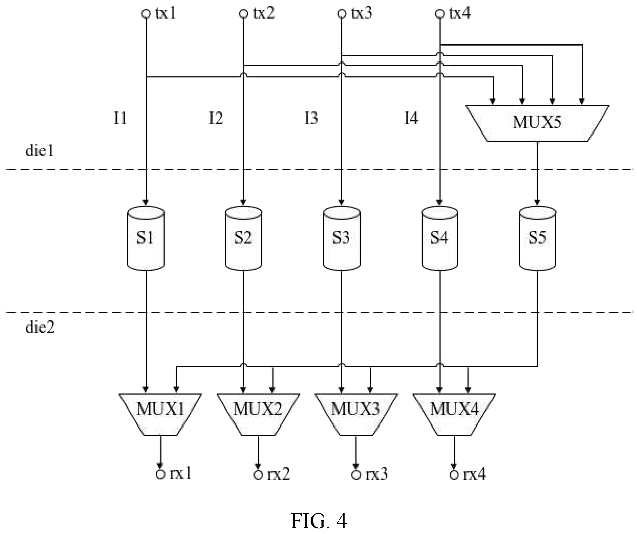

Refer to FIG. 4. FIG. 4 is a diagram of a structure of another semiconductor device according to an embodiment of this application. The semiconductor device includes a first die die1 and a second die die2. The first die die1 includes a plurality of signal sending nodes, for example, a signal sending node tx1, a signal sending node tx2, a signal sending node tx3, and a signal sending node tx4. The second die die2 includes a plurality of signal receiving nodes, for example, a signal receiving node rx1, a signal receiving node rx2, a signal receiving node rx3, and a signal receiving node rx4. The plurality of signal sending nodes of the first die die1 are in a one-to-one correspondence with the plurality of signal receiving nodes of the second die die2. For example, the signal sending node tx1 is configured to send a signal I1 to the signal receiving node rx1 corresponding to the signal sending node tx1, the signal sending node tx2 is configured to send a signal I2 to the signal receiving node rx2 corresponding to the signal sending node tx2, the signal sending node tx3 is configured to send a signal I3 to the signal receiving node rx3 corresponding to the signal sending node tx3, and the signal sending node tx4 is configured to send a signal I4 to the signal receiving node rx4 corresponding to the signal sending node tx4. The node herein may be a node actually existing in the first die die1 or the second die die2, or may be a convergence point of a related electrical connection in the first die die1 or the second die die2.

The first die die1 and the second die die2 may be stacked, and the first die die1 is coupled to the second die die2 through a plurality of interconnects, for example, an interconnect S1, an interconnect S2, an interconnect S3, an interconnect S4, and an interconnect S5. The interconnect S1 may be configured to transmit the signal I1, the interconnect S2 may be configured to transmit the signal I2, the interconnect S3 may be configured to transmit the signal I3, and the interconnect S4 may be configured to transmit the signal I4. The interconnect S5 is a redundant interconnect, and may be configured to replace a faulty interconnect to transmit a signal when the faulty interconnect occurs.

Still refer to FIG. 4. The semiconductor device further includes a plurality of multiplexers on an output side, namely, a MUX1 to a MUX4, and a multiplexer on an input side, namely, a MUX5. To repair any faulty interconnect in the interconnect S1 to the interconnect S4 by using the interconnect S5, an output end of the MUX5 is connected to an input end of the interconnect S5, and four input ends of the MUX5 are connected to the four signal sending nodes (the signal sending node tx1, the signal sending node tx2, the signal sending node tx3, and the signal sending node tx4) of the first die die1 in a one-to-one correspondence. Therefore, the MUX5 may select, based on a control signal, to transmit any one of the signal I1 to the signal I4 through the interconnect S5.

Each signal receiving node of the second die di2 is correspondingly provided with one output-side multiplexer, the output-side multiplexer is a 2-to-1 multiplexer, and the multiplexer may be used to select to receive a signal transmitted through an interconnect corresponding to the signal receiving node or a signal transmitted through a redundant interconnect.

For example, the signal receiving node rx1 is connected to an output end of the MUX1, a first input end of the MUX1 is connected to an output end of the interconnect S1, and a second input end of the MUX1 is connected to an output end of the interconnect S5. The signal receiving node rx2 is connected to an output end of the MUX2, a first input end of the MUX2 is connected to an output end of the interconnect S2, and a second input end of the MUX2 is connected to an output end of the interconnect S5. Similarly, the signal receiving node rx3 is connected to the interconnect S3 and the interconnect S5 through the MUX3, and the signal receiving node rx4 is connected to the interconnect S4 and the interconnect S5 through the MUX4.

The redundant interconnect S5 and the MUX1 to the MUX5 may be used to implement signal-switching-based interface repair. When any one of the interconnect S1 to the interconnect S4 is faulty and cannot normally transmit a signal, the MUX5 may select the interconnect S5 to transmit a signal corresponding to the faulty interconnect, and an output-side multiplexer corresponding to the faulty interconnect may select to output the signal transmitted through the interconnect S5 to the signal receiving node corresponding to the faulty interconnect, thereby completing interconnect repair.

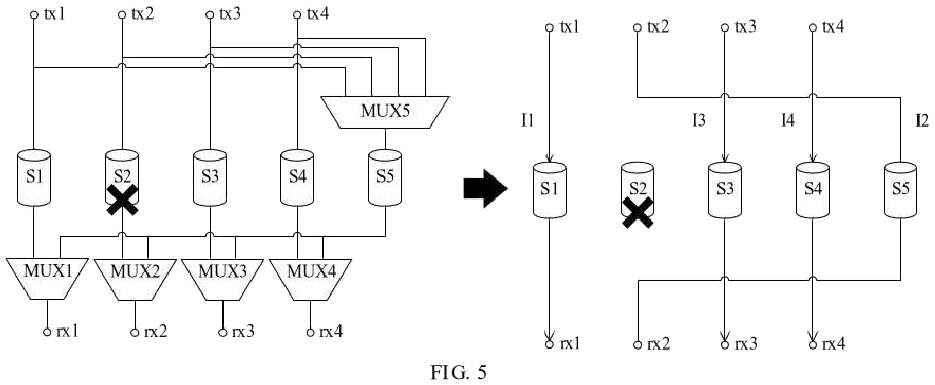

For example, refer to FIG. 5. When the interconnect S2 is faulty, in a signal switching manner, the MUX5 selects to connect the signal sending node tx2 corresponding to the interconnect S2 to the input end of the interconnect S5, and the MUX2 selects to connect the output end of the interconnect S5 to the signal receiving node rx2. In this way, the signal I2 output by the signal sending node tx2 may be transmitted to the signal receiving node rx2 through the interconnect S5.

It can be learned that, when an interconnect becomes faulty, the MUX1 to the MUX5 need to adjust a select state or a select position, so that the interconnect S5 can be used to replace the faulty interconnect to transmit a signal. A position of the faulty interconnect in this group of interconnects may be recorded by a group of binary counting registers, the registers may be encoded in binary mode, and a quantity of the registers is small. However, because the multiplexer on the input side needs to be capable of connecting a signal sending node corresponding to any faulty interface to the interconnect, a many-to-one multiplexer needs to be disposed. A quantity of input ends of the multiplexer matches a quantity of signal sending nodes. As a result, the multiplexer has a more complex structure, a larger quantity of logic gates, a larger occupied area, and a larger signal delay.

In addition, for some interconnects that are far away from the interconnect S5, for example, if the interconnect S1 is faulty and the interconnect S5 is switched to transmit the signal I1, because a distance between the signal sending node tx1 and the interconnect S5 is large, when the signal I1 is transmitted through the interconnect S5, a signal delay is larger, and a signal transmission rate is affected.

The signal-shifting-based interconnect repair solution can avoid problems such as a signal delay. In the signal-shifting-based interconnect repair solution, a redundant interconnect may be set on a left or right side of a group of interconnects. When any interconnect is faulty, a signal may be entirely shifted toward a side on which the redundant interconnect is located, to complete repair.

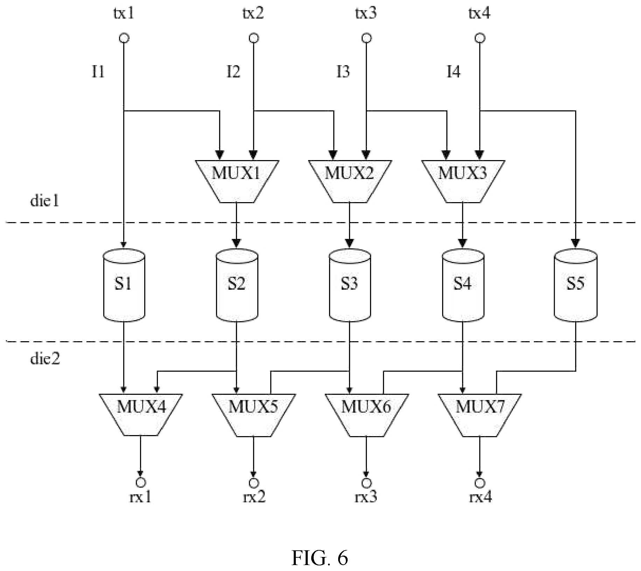

Refer to FIG. 6. FIG. 6 is a diagram of a semiconductor device. The semiconductor device includes a first die die1 and a second die die2. The first die die1 includes a plurality of signal sending nodes, for example, a signal sending node tx1, a signal sending node tx2, a signal sending node tx3, and a signal sending node tx4. The second die die2 includes a plurality of signal receiving nodes, for example, a signal receiving node rx1, a signal receiving node rx2, a signal receiving node rx3, and a signal receiving node rx4. The plurality of signal sending nodes of the first die die1 are in a one-to-one correspondence with the plurality of signal receiving nodes of the second die die2. For example, the signal sending node tx1 is configured to send a signal I1 to the signal receiving node rx1 corresponding to the signal sending node tx1, the signal sending node tx2 is configured to send a signal I2 to the signal receiving node rx2 corresponding to the signal sending node tx2, the signal sending node tx3 is configured to send a signal I3 to the signal receiving node rx3 corresponding to the signal sending node tx3, and the signal sending node tx4 is configured to send a signal I4 to the signal receiving node rx4 corresponding to the signal sending node tx4. The first die die1 is coupled to the second die die2 through a plurality of interconnects such as an interconnect S1, an interconnect S2, an interconnect S3, an interconnect S4, and an interconnect S5. The interconnect S1 may be configured to transmit a signal I1, the interconnect S2 may be configured to transmit a signal I2, the interconnect S3 may be configured to transmit a signal I3, the interconnect S4 may be configured to transmit a signal I4, and the interconnect S5 is a redundant interconnect.

A signal-shifting-based interconnect repair solution means that a signal output by any signal sending node may be transmitted through an interconnect corresponding to the signal sending node, or may be shifted to be transmitted through another adjacent interconnect. For example, the signal I1 may be transmitted through the interconnect S1, or may be shifted rightward to be transmitted through the interconnect S2 adjacent to the interconnect S1; the signal I2 may be transmitted through the interconnect S2, or may be shifted rightward to be transmitted through the interconnect S3; the signal I3 may be transmitted through the interconnect S3, or may be shifted rightward to be transmitted through the interconnect S4; and the signal I4 may be transmitted through the interconnect S4, or may be shifted rightward to be transmitted through the redundant interconnect S5. In this case, a structure formed by connecting the interconnect S1 to the interconnect S4 and the redundant interconnect S5 is referred to as a shift repair chain or a shift transmission circuit.

FIG. 6 shows four interconnects (the interconnect S1 to the interconnect S4) and one redundant interconnect (the interconnect S5) for transmitting four signals. The interconnect S1 to the interconnect S5 are connected through a plurality of multiplexers on an input side and a plurality of multiplexers on an output side to form a shift repair chain. In this embodiment of this application, a unidirectional shift repair chain is used as an example. The multiplexers on the input side are 2-to-1 multiplexers, and a quantity of multiplexers on the input side is two less than a quantity of interconnects. Alternatively, it may be considered that when one redundant interconnect exists in the interconnects, a quantity of multiplexers on the input side is one less than a quantity of to-be-transmitted signals (namely, a quantity of signal sending nodes or a quantity of signal receiving nodes). For example, corresponding to four signal sending nodes, three multiplexers, namely, a MUX1 to a MUX3, are disposed on the input side. The output-side multiplexer are also 2-to-1 multiplexers, and a quantity of output-side multiplexers is one less than the quantity of interconnects. Alternatively, it may be considered that a quantity of output-side multiplexers is the same as the quantity of to-be-transmitted signals (namely, the quantity of signal sending nodes or the quantity of signal receiving nodes). For example, corresponding to four signal receiving nodes (or signal sending nodes), four output-side multiplexers, namely, a MUX4 to a MUX7, are disposed.

The signal sending node tx1 is connected to an input end of the interconnect S1, the signal sending node tx1 is further connected to a first input end of the MUX1, and an output end of the MUX1 is connected to an input end of the interconnect S2. The signal sending node tx2 is connected to a second input end of the MUX1, the signal sending node tx2 is further connected to a first input end of the MUX2, and an output end of the MUX2 is connected to an input end of the interconnect S3. The signal sending node tx3 is connected to a second input end of the MUX2, the signal sending node tx3 is further connected to a first input end of the MUX3, and an output end of the MUX3 is connected to an input end of the interconnect S4. The signal sending node tx4 is connected to a second input end of the MUX3, and the signal sending node tx4 is further connected to an input end of the interconnect S5.

A first input end of the MUX4 is connected to an output end of the interconnect S1, a second input end of the MUX4 is connected to the output end of the interconnect S1, and an output end of the MUX4 is connected to the signal receiving node rx1. A first input end of the MUX5 is connected to an output end of the interconnect S2, a second input end of the MUX5 is connected to the output end of the interconnect S2, and an output end of the MUX5 is connected to the signal receiving node rx2. A first input end of the MUX6 is connected to an output end of the interconnect S3, a second input end of the MUX6 is connected to the output end of the interconnect S3, and an output end of the MUX6 is connected to the signal receiving node rx3. A first input end of the MUX7 is connected to an output end of the interconnect S4, a second input end of the MUX7 is connected to an output end of the interconnect S5, and an output end of the MUX7 is connected to the signal receiving node rx4.

The multiplexers on the input side and the output side may be configured to select an interconnect through which a signal sent by a signal sending node to a signal receiving node is transmitted. For example, when the MUX1 selects, based on a control signal, to connect the first input end to the output end, the signal I1 is transmitted through the interconnect S1. In this case, the MUX4 needs to connect the interconnect S1 to the signal receiving node rx1. When the MUX1 selects, based on the control signal, to connect the second input end to the output end, the signal I1 is shifted rightward and transmitted through the interconnect S2. In this case, the MUX4 needs to connect the interconnect S2 to the signal receiving node rx1.

In this embodiment of this application, the redundant interconnect is located at a right end of the shift repair chain. When any interconnect is faulty, a signal of the faulty interconnect and a signal of an interconnect on the right side of the faulty interconnect may be entirely shifted rightward by one bit, to ensure normal signal transmission and complete repair.

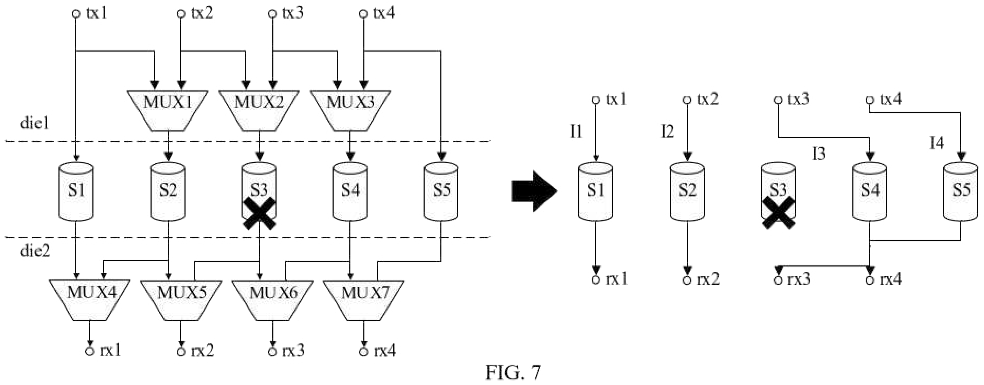

For example, refer to FIG. 7. When the interconnect S3 is faulty, transmission mode of the interconnect S1 and the interconnect S2 on the left side of the interconnect S3 may remain unchanged, that is, the signal I1 is transmitted through the interconnect S1, and the signal I2 is transmitted through the interconnect S2. The signal of the interconnect S3 and the signal of the interconnect S4 are entirely shifted rightward by one bit. In this way, the signal I4 is shifted rightward and transmitted through the interconnect S5, and the signal I3 is shifted rightward and transmitted through the interconnect S4, to repair the interconnect.

In a signal-shifting repair solution, each signal may correspond to one register, and the register may be configured to record an interconnect through which the signal is transmitted. This is more suitable for processing of shift select logic. Therefore, a quantity of gates of combination logic in the structure is small. In addition, in the shift repair solution, each signal may be shifted to be transmitted through an adjacent interconnect, a spacing between adjacent interconnects (compared with a distance from a redundant interconnect in FIG. 4) is small, and a delay of the signal before and after shifting is small. Therefore, a shifting-based signal repair solution is more widely used.

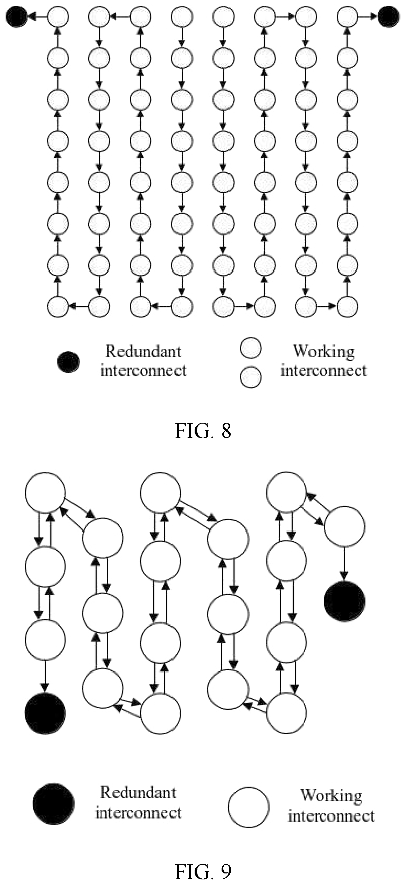

In the foregoing example, only one redundant interconnect is disposed. Therefore, a signal can be only shifted unidirectionally, and only one faulty interconnect can be repaired. When a stronger repair capability is required, a plurality of shift repair chains or shift transmission circuits may be disposed. FIG. 8 shows another repair solution. All interconnects are divided into two groups to form a structure of a shift repair chain, each group of interconnects includes one redundant interconnect, and any faulty interconnect in each group can be repaired through shifting.

Refer to FIG. 8. FIG. 8 is a diagram of signal repair. FIG. 8 shows a plurality of interconnects, where two interconnects are redundant interconnects, and other interconnects are working interconnects. Herein, structures of the redundant interconnects and the working interconnects are the same, a difference between the redundant interconnect and the working interconnect lies in that when the working interconnect is not faulty, the redundant interconnect is not used to transmit data; and when the working interconnect is faulty, the redundant interconnect is used to transmit data. The plurality of interconnects are divided into two groups. As shown in FIG. 8, a plurality of interconnects in each group form a shift repair chain, and each shift repair chain includes one redundant interconnect. A connection manner of the shift repair chain is described in detail in the foregoing example, and details are not described herein again.

In the repair solution shown in FIG. 8, if any faulty interconnect occurs in each group, the faulty interconnect can be repaired through shifting. An advantage of this solution is that the structure is simple, and only one 2-to-1 MUX multiplexer needs to be added to both an input end and an output end of the interconnect, so that a delay is small, and impact on a signal transmission rate is small. However, this structure also has disadvantages. When a bridge fault occurs in any group, the bridge fault cannot be repaired. The bridge fault means that two interconnects are connected. The bridge fault usually occurs between two adjacent interconnects that are close to each other. For example, in a plurality of interconnects arranged in a row-column matrix, two adjacent interconnects located in a same row or a same column are prone to a bridge fault. However, a distance between two interconnects located in a diagonal direction is larger than a distance between two adjacent interconnects located in a same row or a same column, and therefore there is a low probability that a bridge fault occurs.

In the repair solution shown in FIG. 8, if a bridge fault occurs in any group, the two interconnects cannot work. However, there is only one redundant interconnect in the group, so that only one faulty interconnect can be repaired, and two bridged interconnects cannot be repaired. However, for interconnects of a 3D IC, density of the interconnects continuously increases, a spacing between the interconnects continuously decreases, and a probability that a bridge fault occurs between the interconnects increases. Therefore, a repair effect of this solution is greatly reduced.

An embodiment of this application further provides another shift repair solution. Two redundant interconnects are disposed in a shift repair chain. As shown in FIG. 9, a plurality of working interconnects and the redundant interconnects form a bidirectional shift repair chain or shift transmission circuit, and a signal may be shifted bidirectionally. For example, a signal may be shifted leftward or rightward in addition to being transmitted through an interconnect corresponding to the signal. This bidirectional shift solution may be used to repair a bridge fault or the like.

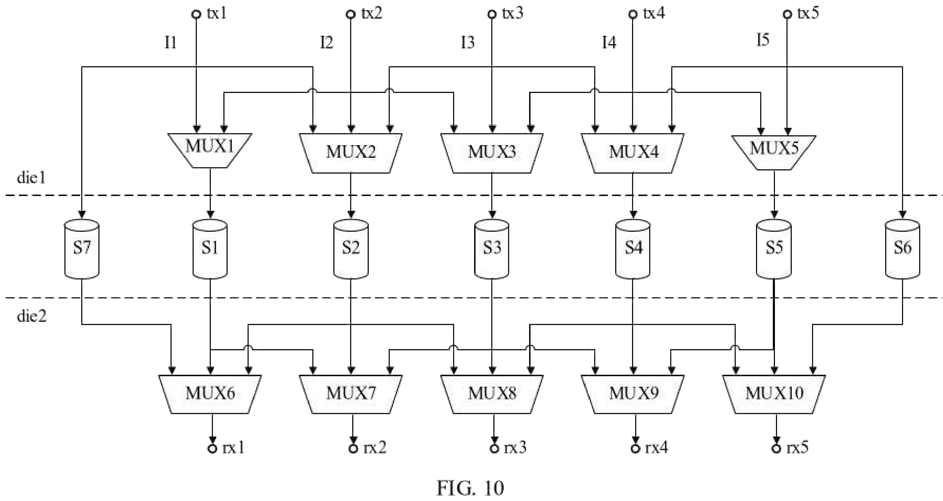

Refer to FIG. 10. FIG. 10 is a diagram of a structure of a semiconductor device. The semiconductor device includes a first die die1 and a second die die2. The first die die1 includes a plurality of signal sending nodes, for example, a signal sending node tx1, a signal sending node tx2, a signal sending node tx3, a signal sending node tx4, and a signal sending node tx5. The second die die2 includes a plurality of signal receiving nodes, for example, a signal receiving node rx1, a signal receiving node rx2, a signal receiving node rx3, a signal receiving node rx4, and a signal receiving node rx5. The plurality of signal sending nodes of the first die die1 are in a one-to-one correspondence with the plurality of signal receiving nodes of the second die die2. For example, the signal sending node tx1 is configured to send a signal I1 to the signal receiving node rx1 corresponding to the signal sending node tx1, the signal sending node tx2 is configured to send a signal I2 to the signal receiving node rx2 corresponding to the signal sending node tx2, ..., and the signal sending node tx5 is configured to send a signal I5 to the signal receiving node rx5 corresponding to the signal sending node tx5.

The first die die1 is coupled to the second die die2 through a plurality of interconnects such as an interconnect S1, an interconnect S2, an interconnect S3, an interconnect S4, an interconnect S5, an interconnect S6, and an interconnect S7. The interconnect S1 may be configured to transmit the signal I1, the interconnect S2 may be configured to transmit the signal I2, the interconnect S3 may be configured to transmit the signal I3, the interconnect S4 may be configured to transmit the signal I4, and the interconnect S5 may be configured to transmit the signal I5. The interconnect S1 to the interconnect S5 may be referred to as working interconnects; and the interconnect S6 and the interconnect S7 are redundant interconnects. The interconnect S6 is disposed on a right side of the working interconnect, and the interconnect S7 is disposed on a left side of the working interconnect.

The interconnect S1 to the interconnect S7 are connected through a plurality of multiplexers on an input side and an output side to form a shift repair chain. A redundant interconnect is disposed at each of two ends of the shift repair chain. A signal sent by each signal sending node may be sent through an interconnect corresponding to the signal sending node, or may be shifted leftward to be sent through an interconnect on a left side of the interconnect, or may be shifted rightward to be sent through an interconnect on a right side of the interconnect.

A plurality of multiplexers, for example, a MUX1 to a MUX5, are disposed on the input side. The MUX1 and the MUX5 are multiplexers at two ends of the shift repair chain, and are both 2-to-1 multiplexers. The MUX2 to the MUX4 are 3-to-1 multiplexers. The signal sending node tx1 is connected to an input end of the interconnect S7, the signal sending node tx1 is further connected to a first input end of the MUX1, and the signal sending node tx1 is further connected to a first input end of the MUX2. The signal sending node tx2 is connected to a second input end of the MUX1, the signal sending node tx2 is further connected to a second input end of the MUX2, and the signal sending node tx2 is further connected to a first input end of the MUX3. The signal sending node tx3 is connected to a third selection end of the MUX2, the signal sending node tx3 is further connected to a second input end of the MUX3, and the signal sending node tx3 is further connected to a first input end of the MUX4. The signal sending node tx4 is connected to a third selection end of the MUX3, the signal sending node tx4 is further connected to a second input end of the MUX4, and the signal sending node tx4 is further connected to a first input end of the MUX5. The signal sending node tx5 is connected to a third selection end of the MUX4, the signal sending node tx5 is further connected to a second input end of the MUX5, and the signal sending node tx5 is further connected to an input end of the redundant interconnect S6. An output end of the MUX1 is connected to an input end of the interconnect S1, an output end of the MUX2 is connected to an input end of the interconnect S2, an output end of the MUX3 is connected to an input end of the interconnect S3, an output end of the MUX4 is connected to an input end of the interconnect S4, and an output end of the MUX5 is connected to an input end of the interconnect S5.

A plurality of output-side multiplexers, for example, a MUX6 to a MUX10, are also disposed. The MUX6 to the MUX10 are all 3-to-1 multiplexers. A first input end of the MUX6 is connected to an output end of the redundant interconnect S7, a second input end of the MUX6 is connected to an output end of the interconnect S1, a third selection end of the MUX6 is connected to an output end of the interconnect S2, and an output end of the MUX6 is connected to the signal receiving node rx1; a first input end of the MUX7 is connected to the output end of the interconnect S1, a second input end of the MUX7 is connected to the output end of the interconnect S2, a third selection end of the MUX7 is connected to an output end of the interconnect S3, and an output end of the MUX7 is connected to the signal receiving node rx1; a first input end of the MUX8 is connected to the output end of the interconnect S2, a second input end of the MUX8 is connected to the output end of the interconnect S3, a third selection end of the MUX8 is connected to an output end of the interconnect S4, and an output end of the MUX8 is connected to the signal receiving node rx2; ...; and a first input end of the MUX10 is connected to the output end of the interconnect S4, a second input end of the MUX10 is connected to an output end of the interconnect S5, a third selection end of the MUX10 is connected to an output end of the redundant interconnect S6, and an output end of the MUX10 is connected to the signal receiving node rx5.

The multiplexers on the input side and the output side may be configured to select an interconnect through which a signal sent by a signal sending node to a signal receiving node is transmitted. For example, when the MUX1 selects, based on a control signal, to connect the first input end to the output end, the signal I1 is transmitted through the interconnect S1. In this case, the MUX6 needs to connect the interconnect S1 to the signal receiving node rx1. When the MUX1 selects, based on the control signal, to connect the second input end to the output end, the signal I1 is shifted rightward and transmitted through the interconnect S2. In this case, the MUX6 needs to connect the interconnect S2 to the signal receiving node rx1.

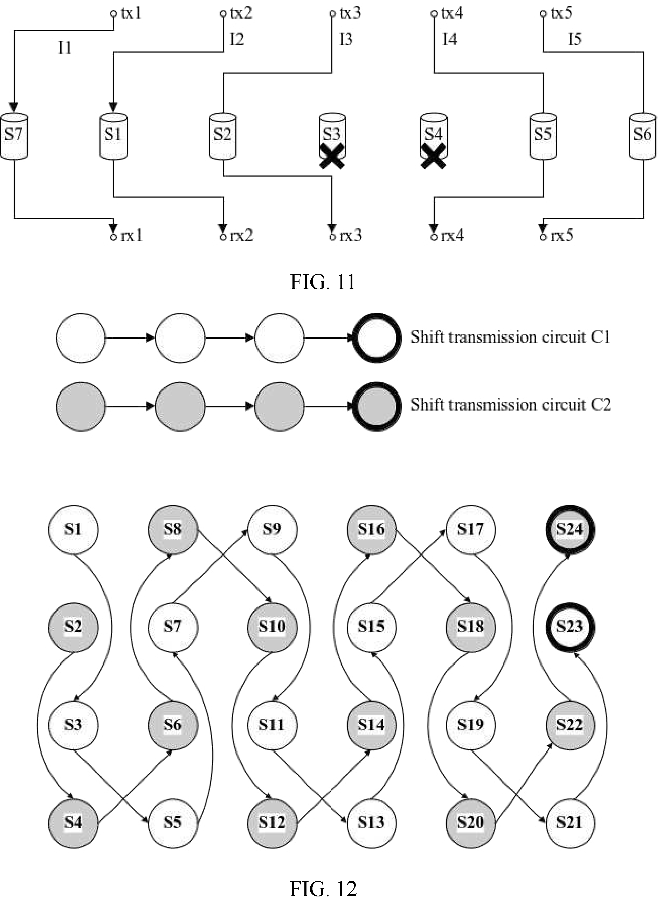

When a bridge fault occurs on any two interconnects, for example, as shown in FIG. 11, when the interconnect S3 and the interconnect S4 are faulty, the signal I3 corresponding to the interconnect S3 is shifted leftward and transmitted through the interconnect S2, the signal I2 corresponding to the interconnect S2 is shifted leftward and transmitted through the interconnect S1, the signal I1 corresponding to the interconnect S1 is shifted leftward and transmitted through the redundant interconnect S7, the signal I4 corresponding to the interconnect S4 is shifted rightward and transmitted through the interconnect S5, and the signal I5 corresponding to the interconnect S5 is transmitted through the redundant interconnect S6. By setting two redundant interconnects S6 and S7, bidirectional shifting may be performed when a bridge fault occurs, some signals are shifted leftward, and the other signals are shifted rightward, to complete bridge fault repair.

In the foregoing solution, a bridge fault that occurs between interconnects can be repaired. However, a plurality of 3-to-1 multiplexers need to be disposed on input sides of the interconnects, and are configured to select one of three signal sending nodes for connection, to transmit a signal output by the signal sending node. One 3-to-1 multiplexer is disposed on an output end of each interconnect, and is configured to select one of signals transmitted through three interconnects and output the selected signal to a signal receiving node. The 3-to-1 multiplexer has a larger delay. Therefore, this solution has a greater impact on a signal transmission delay, and affects a signal transmission rate in an application scenario of cross-die high-speed transmission.

It can be learned from the foregoing content that, the bridge fault of the interconnects can be repaired by constructing the shift transmission circuit based on the 3-to-1 multiplexer. However, the 3-to-1 multiplexer has a large delay, which affects a signal transmission rate. The shift transmission circuit constructed based on the 2-to-1 multiplexer shown in FIG. 6 has a small delay, but a bridge fault cannot be repaired when the bridge fault occurs. To alleviate the foregoing problem, an embodiment of this application provides an interconnect repair solution, to implement a repair solution by using a 2-to-1 multiplexer, thereby avoiding increasing a signal delay and affecting a transmission rate, and repair a conventional open fault, a short fault, a delay fault, and a bridge fault.

An embodiment of this application provides a semiconductor device, including a first die, a second die, and a plurality of interconnects. The first die is coupled to the second die through the plurality of interconnects. The first die includes a plurality of signal sending nodes, the second die includes a plurality of signal receiving nodes, and the signal sending node of the first die may send a signal to the signal receiving node of the second die through the interconnect.

An open fault or a bridge fault may occur on the interconnect in the semiconductor device. To repair the fault of the interconnect, the first die includes a plurality of shift sending circuits, and the second die includes a plurality of shift receiving circuits, and the plurality of shift sending circuits, the plurality of shift receiving circuits, and the plurality of interconnects between the first die and the second die form a plurality of shift transmission circuits, or may be referred to as a plurality of shift repair chains. In consideration of a signal delay, the shift transmission circuit may be a unidirectional shift transmission circuit. For example, n signal sending nodes are coupled to n signal receiving nodes through the shift transmission circuit, and the shift transmission circuit includes n+1 interconnects. For example, a signal of an i^{th} signal sending node may be transmitted through an i^{th} interconnect or shifted to an (i+1)^{th} interconnect for transmission. For example, generally, the signal of the i^{th} signal sending node is sent through the i^{th} interconnect, and if the i^{th} interconnect is faulty, the signal may be shifted to the (i+1)^{th} interconnect for sending; and a signal of an (i+1)^{th} signal sending node is transmitted through an (i+2)^{th} interconnect. By analogy, a signal of an n^{th} signal sending node is transmitted through an (n+1)^{th} interconnect. In this way, when any interconnect is faulty, the faulty interconnect may be repaired through signal shifting. The i^{th} signal sending node, an i^{th} signal receiving node, the i^{th} interconnect, or the like herein is a logical concept, and does not constitute a limitation on a position of the signal sending node, the signal receiving node, or the interconnect.

The semiconductor device includes the plurality of interconnects, and any two adjacent interconnects are located in different shift transmission circuits. For example, refer to FIG. 12. FIG. 12 is a diagram of arrangement of some interconnects (an interconnect S1 to an interconnect S24) of the semiconductor device. The interconnect S1 to the interconnect S24 may be arranged in a multi-row and multi-column matrix, and the interconnect S1 to the interconnect S24 may be located in two shift transmission circuits, so that any two adjacent interconnects are located in different shift transmission circuits. An arrow direction in the figure is a signal shift direction. In this way, when a bridge fault occurs on the adjacent interconnects, the bridge fault of the two interconnects may be converted into a fault of a single interconnect in the two shift transmission circuits, and shift repair of the single interconnect may be implemented in the two shift transmission circuits separately, to repair the bridge fault of the two interconnects.

A plurality of interconnects may be respectively reserved for the first die and the second die. For example, a plurality of first interconnects are disposed on the first die, a plurality of second interconnects are disposed on the second die, the plurality of first interconnects match the plurality of second interconnects in terms of quantity and position, and the first interconnects and the second interconnects may be connected in a one-to-one correspondence through the interconnects, to form a shift transmission circuit.

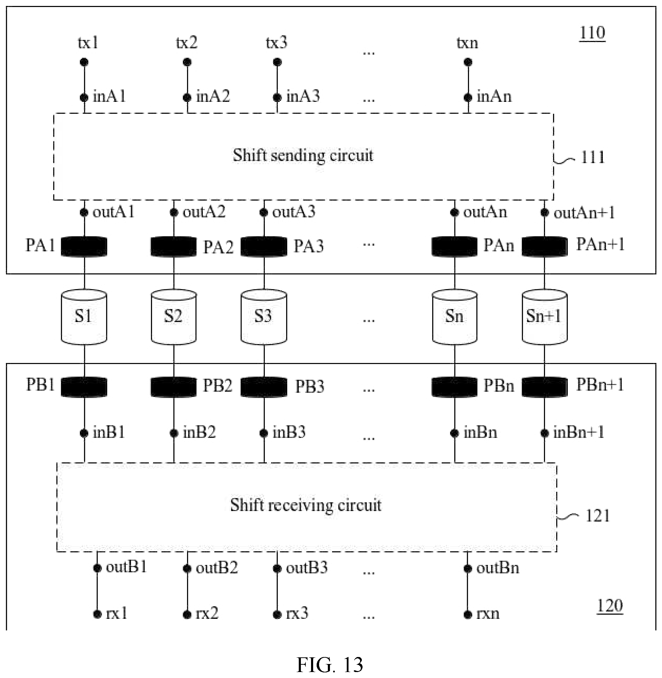

For example, refer to FIG. 13. FIG. 13 is a diagram of another semiconductor device. The semiconductor device includes a plurality of shift transmission circuits. For ease of description, FIG. 13 is a diagram of only one of the shift transmission circuits.

A first die 110 includes a plurality of signal sending nodes (for example, a signal sending node tx1 to a signal sending node txn), a shift sending circuit 111, and a plurality of first interconnects (for example, a first interconnect PA1 to a first interconnect PAn+1). The shift sending circuit 111 includes a plurality of signal input ends (for example, a signal input end inA1 to a signal input end inAn) and a plurality of signal output ends (for example, a signal output end outA1 to a signal output end outAn+1). A signal input at an i^{th} signal input end is configured to be output from an i^{th} signal output end or an (i+1)^{th} signal output end, where i is a positive integer. For example, a signal input at the signal output end outA1 may be output from the signal output end outA1 or the signal output end outA2. The plurality of signal input ends of the shift sending circuit 111 are separately connected to one signal sending node, and the plurality of signal output ends of the shift sending circuit 111 are separately connected to one first interconnect. For example, the signal input end inA1 is connected to the signal sending node tx1, ..., the signal input end inAn is connected to the signal sending node txn, the signal output end outA1 is connected to the first interconnect PA1, ..., the signal output end outAn is connected to the first interconnect PAn, and the signal output end outAn+1 is connected to the first interconnect PAn+1. FIG. 13 shows only one shift sending circuit of the first die 110. The first die 110 includes a plurality of shift sending circuits, and any two adjacent first interconnects of the first die 110 are connected to different shift sending circuits.

The second die 120 includes a plurality of signal receiving nodes (for example, a signal receiving node rx1 to a signal receiving node rxn), a shift receiving circuit 121, and a plurality of second interconnects (for example, a second interconnect PB1 to a second interconnect PBn+1). The shift receiving circuit 121 includes a plurality of signal input ends (for example, a signal input end inB1 to a signal input end inBn+1) and a plurality of signal output ends (for example, a signal output end outB1 to a signal output end outBn). An i^{th} signal output end of the shift receiving circuit 121 is configured to output a signal input at an i^{th} signal input end or an (i+1)^{th} signal input end. For example, the signal output end outB1 of the shift receiving circuit 121 may output a signal of the signal input end inB1 of the shift receiving circuit 121 or a signal of a signal input end inB2 of the shift receiving circuit 121, and a signal output end outB2 of the shift receiving circuit 121 may output the signal of the signal input end inB2 of the shift receiving circuit 121 or a signal of a signal input end inB3 of the shift receiving circuit 121. The plurality of signal input ends of the shift receiving circuit 121 are separately connected to one second interconnect, and the plurality of signal output ends of the shift receiving circuit 121 are separately connected to one signal receiving node. For example, the signal input end inB1 of the shift receiving circuit 121 is connected to the second interconnect PB1 of the second die 120, ..., the signal input end inBn is connected to a second interconnect PBn, and the signal input end inBn+1 is connected to the second interconnect PBn+1. FIG. 13 shows only one shift receiving circuit of the second die 120. The second die 120 includes a plurality of shift receiving circuits, and any two adjacent second interconnects of the second die 120 are connected to different shift receiving circuits.

The shift sending circuit 111 of the first die 110 includes a plurality of signal output ends, and each signal output end is connected to one first interconnect. The shift receiving circuit 121 of the second die 120 includes a plurality of signal input ends, each signal input end is connected to one second interconnect, and each first interconnect may be connected to one second interconnect in a one-to-one correspondence through one interconnect. In this way, the shift sending circuit, the interconnect, and the shift receiving circuit may form a shift transmission circuit.

For example, an i^{th} signal output end of the shift sending circuit is connected to an i^{th} signal input end of the shift receiving circuit through an i^{th} interconnect. Specifically, a first interconnect connected to the i^{th} signal output end of the shift sending circuit is connected to a second interconnect connected to the i^{th} signal input end of the shift receiving circuit through the i^{th} interconnect.

During production, a first die and a second die may be first prepared, then the first die and the second die are stacked, and the first die is coupled to the second die through an interconnect. Alternatively, a first die and a second die may be prepared at the same time, and a plurality of interconnects are formed when the first die and the second die are prepared, to couple the first die and the second die.

In the foregoing example, one shift transmission circuit of the semiconductor device is used as an example to describe a manner in which the first die is coupled to the second die through the plurality of interconnects to form the shift transmission circuit. The shift transmission circuit provided in this embodiment of this application may repair a single faulty interconnect through signal-shifting transmission. In actual application, the semiconductor device includes a plurality of shift transmission circuits, and any two adjacent interconnects of the semiconductor device are located in different shift transmission circuits, in other words, shift sending circuits connected to any two adjacent interconnects of the semiconductor device are different, and shift receiving circuits connected to the two adjacent interconnects are different. When a bridge fault occurs on the two adjacent interconnects, the bridge fault may be converted into a fault of a single interconnect in two different shift transmission circuits, and is repaired through signal-shifting transmission.

Two adjacent interconnects mean that a distance between the two interconnects (for example, a first interconnect and a second interconnect) is less than or equal to a distance between one of the interconnects and any other interconnect, for example, a distance between a first interconnect and a second interconnect that are adjacent to each other is less than or equal to a distance between the first interconnect and any third interconnect, or the distance between the first interconnect and the second interconnect is less than or equal to a distance between the second interconnect and any third interconnect.

There is a high probability that a bridge fault occurs between two interconnects that are close to each other. Therefore, it is only required that any two adjacent interconnects are located in different shift transmission circuits. When a bridge fault occurs on the two adjacent interconnects, a shift transmission circuit in which the faulty interconnect is located may perform shift repair on the faulty interconnect.

A shift sending circuit is connected to a corresponding shift receiving circuit through an interconnect to form a shift transmission circuit, so that a signal of a signal sending node may be transmitted to a signal receiving node. A principle of the shift sending circuit of the first die is similar to that of the shift receiving circuit of the second die. In this embodiment of this application, the shift sending circuit of the first die is first used as an example for description.

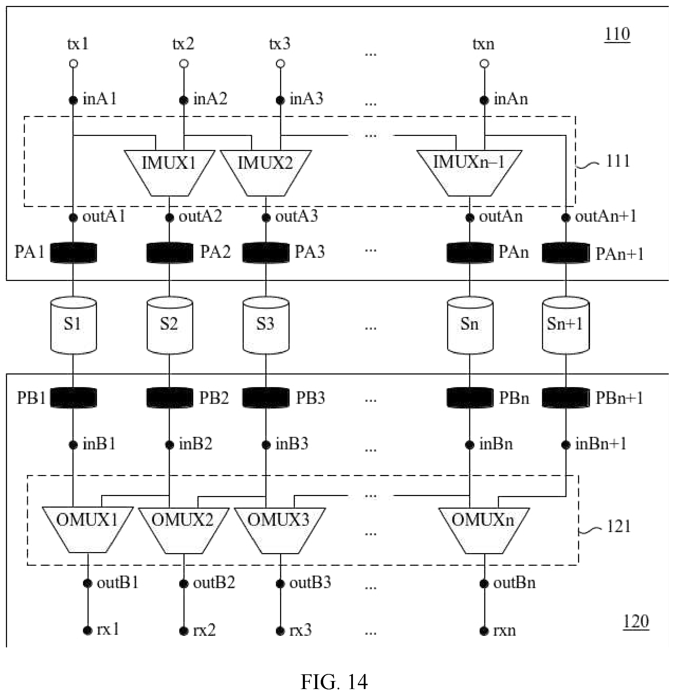

For example, refer to FIG. 14. A shift sending circuit 111 includes n signal input ends (for example, a signal input end inA1 to a signal input end inAn), n+1 signal output ends (for example, a signal output end outA1 to a signal output end outAn+1), and n-1 multiplexers (for example, an IMUX1 to an IMUXn-1). The multiplexers are 2-to-1 multiplexers, and the multiplexer includes a first input end, a second input end, and an output end. A first input end of an m^{th} multiplexer in the n-1 multiplexers is connected to an m^{th} signal input end of the shift sending circuit, a second input end of the m^{th} multiplexer in the n-1 multiplexers is connected to an (m+1)^{th} signal input end of the shift sending circuit, and an output end of the m^{th} multiplexer in the n-1 multiplexers is connected to an (m+1)^{th} signal output end of the shift sending circuit, where m and n are positive integers, and m≤n-1. A 1 ^{st} signal input end of the shift sending circuit is further connected to a 1^{st} signal output end of the shift sending circuit (for example, the signal input end inA1 is connected to the signal output end outA1); and an n^{th} signal input end of the shift sending circuit is further connected to an (n+1)^{th} signal output end of the shift sending circuit (for example, the signal input end inAn is connected to the signal output end outAn+1). In addition, as described in the foregoing example, each signal output end of the shift sending circuit 111 is connected to one first interconnect, in other words, each signal output end may correspond to one interconnect, and the n signal input ends of the shift sending circuit correspond to n+1 interconnects.

A semiconductor device includes a plurality of shift transmission circuits. Correspondingly, a first die includes a plurality of signal sending nodes and a plurality of shift sending circuits. Quantities of signal input ends of different shift sending circuits are the same or different. A second die includes a plurality of signal receiving nodes and a plurality of shift receiving circuits, and the plurality of shift receiving circuits of the second die are in a one-to-one correspondence with the shift sending circuits of the first die.

For example, if the shift sending circuit 111 of the first die 110 includes n signal input ends and n+1 signal output ends, a shift receiving circuit 121 of the second die 120 includes n+1 signal input ends and n signal output ends. The n+1 signal input ends of the shift receiving circuit 121 are in a one-to-one correspondence with the n+1 signal output ends of the shift sending circuit 111 of the first die 110. In the shift receiving circuit 121, an i^{th} signal output end is configured to output a signal input at an i^{th} signal input end or an (i+1)^{th} signal input end, where i is a positive integer. A plurality of signal input ends of the shift receiving circuit 121 are separately connected to one second interconnect, a plurality of signal output ends of the shift receiving circuit 121 are separately connected to one signal receiving node, and any two adjacent second interconnects of the second die are connected to different shift receiving circuits.

The shift receiving circuit 121 further includes n multiplexers (for example, an OMUX1 to an OMUXn), and the multiplexer includes a first input end, a second input end, and an output end. In the shift receiving circuit 121, a first input end of an m^{th} multiplexer in the n multiplexers of the shift receiving circuit 121 is connected to an m^{th} signal input end of the shift receiving circuit 121, a second input end of the m^{th} multiplexer in the n multiplexers of the shift receiving circuit 121 is connected to an (m+1)^{th} signal input end of the shift receiving circuit 121, and an output end of the m^{th} multiplexer in the n multiplexers of the shift receiving circuit 121 is connected to an m^{th} signal output end of the shift receiving circuit 121, where m and n are positive integers, and m≤n-1. In addition, as described in the foregoing example, each signal input end of the shift receiving circuit 121 is connected to one second interconnect, in other words, each signal input end corresponds to one interconnect, and n+1 signal input ends of the shift receiving circuit 121 correspond to n+1 interconnects. Any two adjacent second interconnects of the second die are connected to different shift sending circuits, in other words, any two adjacent interconnects of the semiconductor device are connected to different shift receiving circuits 121.

In other words, any two adjacent interconnects of the semiconductor device are connected to different shift transmission circuits. In this way, when a bridge fault occurs on any two adjacent interconnects, because the two adjacent interconnects are connected to different shift transmission circuits, the faulty interconnects may be respectively repaired by using the shift transmission circuits connected to the two adjacent interconnects. In addition, because the shift transmission circuit is a unidirectional repair chain, only a plurality of 2-to-1 multiplexers need to be disposed to implement repair. Compared with setting a bidirectional repair chain by using a 3-to-1 multiplexer, this can reduce a signal delay and reduce impact on a signal transmission rate.

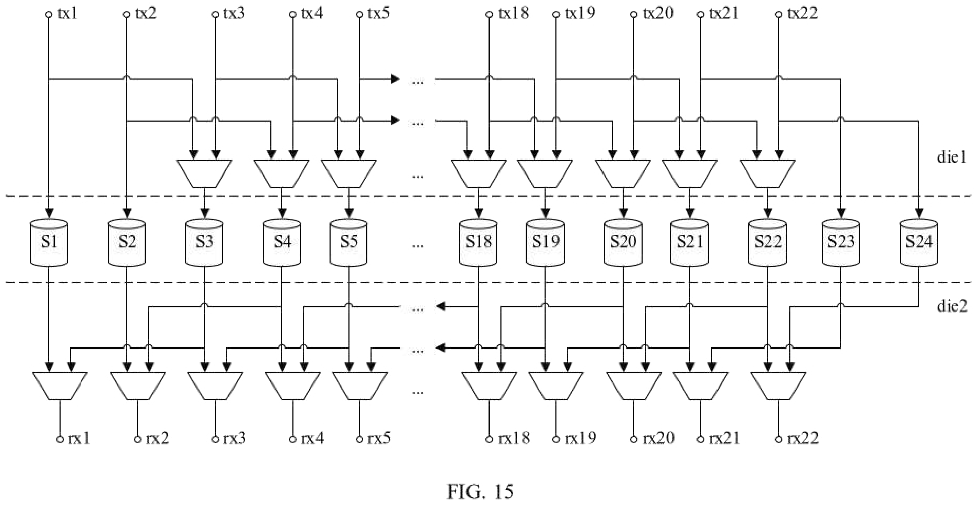

Refer to FIG. 15. FIG. 15 is a diagram of a semiconductor device according to an embodiment of this application. The semiconductor device includes a plurality of shift transmission circuits. FIG. 15 shows two shift transmission circuits of the semiconductor device. The semiconductor device includes a first die and a second die. The first die is coupled to the second die through a plurality of interconnects (for example, an interconnect S1 to an interconnect S24). The first die includes a plurality of signal sending nodes (for example, a signal sending node tx1 to a signal sending node tx22), and the second die includes a plurality of signal receiving nodes (for example, a signal receiving node rx1 to a signal receiving node rx22).

For example, the interconnect S1 to the interconnect S24 are sequentially disposed. For example, the interconnect S1 is adjacent to the interconnect S2, the interconnect S2 is adjacent to the interconnect S3, ..., and the interconnect S23 is adjacent to the interconnect S24.

The interconnect S1, the interconnect S3, the interconnect S5, ..., the interconnect S21, and the interconnect S23 are connected to a first shift sending circuit of the first die and a first shift receiving circuit of the second die to form a first shift transmission circuit. The interconnect S2, the interconnect S4, the interconnect S6, ..., the interconnect S22, and the interconnect S24 are connected to a second shift sending circuit of the first die and a second shift receiving circuit of the second die to form a second shift transmission circuit.

A manner of forming the shift transmission circuit is described in detail in the foregoing example, and details are not described herein again. The following describes, with reference to FIG. 15, a principle of repairing a bridge fault of a semiconductor device according to an embodiment of this application. Because there is a high probability that the bridge fault occurs between two adjacent interconnects, an example in which the bridge fault occurs between the interconnect S18 and the interconnect S19 is used for description.

For the interconnect S18, the signal sending node tx18 cannot transmit a signal to the signal receiving node rx18 through the interconnect S18. A multiplexer in the second shift transmission circuit connects the signal sending node tx18 and the signal receiving node rx18 to the interconnect S20 that is in the second shift transmission circuit and that is shifted rightward by one bit from the interconnect S18, connects the signal sending node tx20 and the signal receiving node rx20 to the interconnect S22 that is in the second shift transmission circuit and that is shifted rightward by one bit from the interconnect S20, and connects the signal sending node tx22 and the signal receiving node rx22 to the interconnect S24 that is in the second shift transmission circuit and that is shifted rightward by one bit from the interconnect S22.

For the interconnect S19, the signal sending node tx19 cannot transmit a signal to the signal receiving node rx19 through the interconnect S19. A multiplexer in the first shift transmission circuit connects the signal sending node tx19 and the signal receiving node rx19 to the interconnect S21 that is in the first shift transmission circuit and that is shifted rightward by one bit from the interconnect S19, connects the signal sending node tx21 and the signal receiving node rx21 to the interconnect S23 that is in the first shift transmission circuit and that is shifted rightward by one bit from the interconnect S21, and connects the signal sending node tx23 and the signal receiving node rx23 to the interconnect S25 that is in the first shift transmission circuit and that is shifted rightward by one bit from the interconnect S23.

In the foregoing example, a plurality of interconnects are located in two shift transmission circuits. In this case, the plurality of interconnects may be arranged in rows and columns, and any two adjacent interconnects in a same row or a same column are located in different shift transmission circuits. For example, the plurality of interconnects may be arranged in a snake-shaped arrangement manner, interconnects with odd serial numbers are arranged in a unidirectional shift transmission circuit, and interconnects with even serial numbers are arranged in a unidirectional shift transmission circuit. In this way, any two adjacent interconnects are located in different shift transmission circuits, and when a bridge fault occurs on adjacent interconnects, the two adjacent interconnects may be respectively repaired by using different shift transmission circuits.

An embodiment of this application further provides another deployment manner of shift transmission circuits. For example, a plurality of interconnects are arranged in a plurality of rows and a plurality of columns. Because a bridge fault usually occurs between two adjacent interconnects in a same row or between two adjacent interconnects in a same column, a bridge fault is not likely to occur on two interconnects located on a same diagonal. This embodiment of this application provides a deployment manner of shift transmission circuits. Interconnects located on a same diagonal are disposed in a same shift transmission circuit, and interconnects on adjacent diagonals are located in different shift transmission circuits. In this way, any two adjacent interconnects can be located in different shift transmission circuits.

Alternatively, it may be considered that the semiconductor device includes a first shift transmission circuit and a second shift transmission circuit. At least one interconnect located in the second shift transmission circuit exists between any two interconnects located in a same row or column in the first shift transmission circuit, and the second shift transmission circuit is different from the first shift transmission circuit.

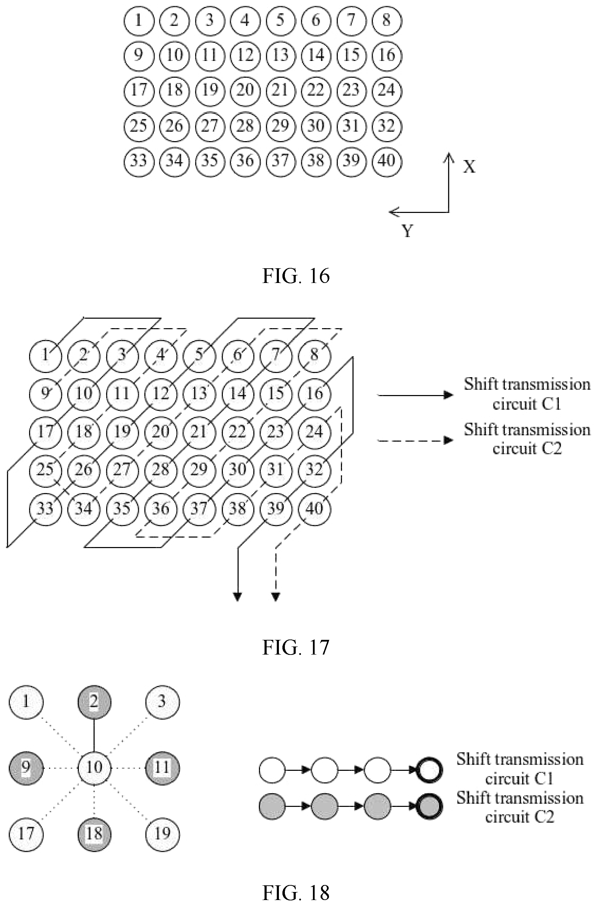

Refer to FIG. 16. FIG. 16 is a diagram of a plurality of interconnects of a semiconductor device, which are respectively marked as 1 to 40. The 40 interconnects include five rows and eight columns distributed in an X direction and a Y direction. The following describes, based on the plurality of interconnects shown in FIG. 16, a deployment manner of shift transmission circuits provided in an embodiment of this application.

Refer to FIG. 17. In a possible implementation, the five rows and eight columns of interconnects may be connected in series, spaced by one diagonal, to form a shift transmission circuit. For example, in a fixed direction, interconnects distributed along an odd number of diagonals are connected in series to form a shift transmission circuit, and interconnects distributed along an even number of diagonals are connected in series to form a shift transmission circuit. For example, interconnects 1, 3, 10, 17, 33, 26, 19, 12, 5, 7, 14, 21, 28, 35, 37, 30, 23, 16, 32, and 39 are located in a shift transmission circuit C1, and interconnects 9, 2, 4, 11, 18, 25, 34, 27, 20, 13, 6, 8, 15, 22, 29, 36, 38, 31, 24, and 40 are located in a shift transmission circuit C2. In this way, the 40 interconnects form two shift transmission circuits, one redundant interconnect is disposed in each shift transmission circuit, and a total of two redundant interconnects need to be disposed. For example, refer to FIG. 18. It can be found by capturing a plurality of interconnects in any area in FIG. 17 that, any two adjacent interconnects are located in different shift transmission circuits, and may be repaired when a bridge fault occurs between the interconnects, for example, between an interconnect 1 and an interconnect 2, or between an interconnect 9 and an interconnect 10. Interconnects located on a same diagonal may be located in a same shift transmission circuit. For example, the interconnect 1, the interconnect 10, and the interconnect 19 are located in a same shift transmission circuit.

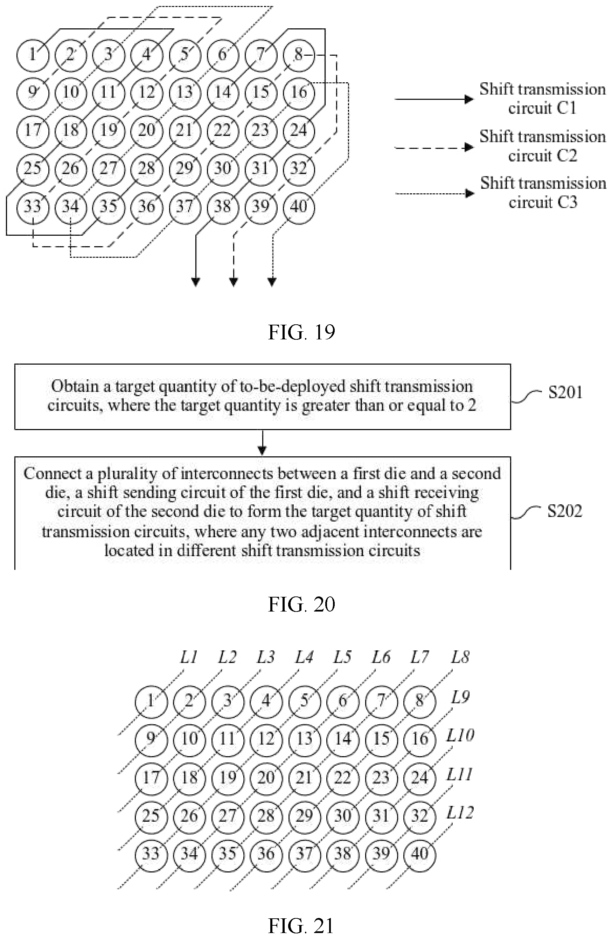

Refer to FIG. 19. Alternatively, in another possible implementation, interconnects spaced by two diagonals may be disposed in a same shift transmission circuit. For example, the 40 interconnects include 12 diagonals in a same direction, interconnects distributed along the 1^{st}, 4^{th}, 7^{th}, and 10^{th} diagonals are disposed in a same shift transmission circuit, interconnects distributed along the 2^{nd}, 5^{th}, 8^{th}, and 11^{th} diagonals are disposed in a same shift transmission circuit, and interconnects distributed along the 3^{rd}, 6^{th}, 9^{th}, and 12^{th} diagonals are disposed in a same shift transmission circuit. As shown in FIG. 19, interconnects 1, 4, 11, 18, 25, 35, 28, 21, 14, 7, 24, 31, and 38 are located in a shift transmission circuit C1, interconnects 9, 2, 5, 12, 19, 26, 33, 36, 29, 22, 15, 8, 32, and 39 are located in a shift transmission circuit C2, and interconnects 17, 10, 3, 6, 13, 20, 27, 34, 37, 30, 23, 16, and 40 are located in a shift transmission circuit C3. In this way, 40 interconnects may be disposed in three shift transmission circuits, and any two adjacent interconnects are located in different shift transmission circuits.

Alternatively, interconnects spaced by three or more diagonals may be disposed in a same shift transmission circuit, so that four or more shift transmission circuits may be disposed for the 40 interconnects.

For example, refer to FIG. 17. At least one interconnect located in the shift transmission circuit C2 exists between any two interconnects in a same row or a same column in the shift transmission circuit C1. For example, the interconnect 1 and the interconnect 3 are located in the shift transmission circuit C1, and the interconnect 2 located in the shift transmission circuit C2 exists between the interconnect 1 and the interconnect 3. For another example, the interconnect 10 and the interconnect 26 are located in the shift transmission circuit C1, and the interconnect 18 located in the shift transmission circuit C2 exists between the interconnect 10 and the interconnect 26.

Refer to FIG. 19. Alternatively, at least one interconnect located in the shift transmission circuit C2 and at least one interconnect located in the shift transmission circuit C3 exist between any two interconnects in a same row or column in the shift transmission circuit C1. For example, the interconnect 1 and the interconnect 4 are located in the shift transmission circuit C1, and the interconnect 2 and the interconnect 3 exist between the interconnect 1 and the interconnect 4, where the interconnect 2 is located in the shift transmission circuit C2, and the interconnect 3 is located in the shift transmission circuit C3.

To automatically connect a plurality of interconnects in series to form a shift transmission circuit (shift repair chain) by using an electronic design automation (electronic design automation, EDA) tool in an integrated circuit design process, and improve an automation level of integrated circuit design, an embodiment of this application further provides a design method for a semiconductor device, so that a deployment of shift transmission circuits may be automatically calculated and completed based on an arrangement and a quantity of interconnects between two dies, a quantity of redundant interconnects, and the like.

For ease of description, in this embodiment of this application, the method provided in this embodiment of this application is described by using an example in which interconnects between two dies shown in FIG. 16 are arranged in an interconnect array with a plurality of rows and a plurality of columns. Refer to FIG. 20. The method includes the following steps.

S201: Obtain a target quantity of to-be-deployed shift transmission circuits, where the target quantity is greater than or equal to 2.

In consideration of a signal transmission delay and deployment costs, the shift transmission circuit provided in this embodiment of this application is a unidirectional shift transmission circuit. One redundant interconnect may be disposed in each shift transmission circuit. In other words, a quantity of shift transmission circuits is the same as a quantity of redundant interconnects, the target quantity of the to-be-deployed shift transmission circuits may be a quantity preset by a user. For example, to ensure that faults of any two interconnects can be repaired, the target quantity is greater than or equal to 2.

S202: Connect a plurality of interconnects between a first die and a second die to a shift sending circuit of the first die and a shift receiving circuit of the second die, to form the target quantity of shift transmission circuits, where any two adjacent interconnects are located in different shift transmission circuits.

According to the design method provided in this embodiment of this application, interconnects in a semiconductor device may be disposed in the target quantity of shift transmission circuits based on the target quantity of the to-be-deployed shift transmission circuits, and any two adjacent interconnects are located in different shift transmission circuits. For example, the interconnects are connected to the shift sending circuit of the first die and the shift receiving circuit of the second die, where the shift sending circuit includes a plurality of signal input ends and a plurality of signal output ends, a signal input at an i^{th} signal input end of the shift sending circuit is configured to be output from an i^{th} signal output end or an (i+1)^{th} signal output end of the shift sending circuit, the shift receiving circuit includes a plurality of signal input ends and a plurality of signal output ends, an i^{th} signal output end of the shift receiving circuit is configured to output a signal input at an i^{th} signal input end or an (i+1)^{th} signal input end of the shift receiving circuit, the i^{th} signal output end of the shift sending circuit is connected to the i^{th} signal input end of the shift receiving circuit through an i^{th} interconnect, and i is a positive integer.

In a possible implementation, the plurality of interconnects between the first die and the second die are arranged in an interconnect array with a plurality of rows and a plurality of columns. For example, refer to FIG. 21. The plurality of interconnects may be divided into a plurality of groups in a direction of a diagonal of the interconnect array, and a connection line between each group of interconnects is a straight line parallel to the diagonal of the interconnect array, for example, L1 to L12 shown in FIG. 21. Connection lines of interconnects in each group are parallel to each other. S202 may include the following steps.

S2021: Divide the interconnect array into a plurality of interconnect groups in a diagonal direction of the interconnect array, where connection lines of interconnects in each interconnect group are parallel to each other.

S2022: Connect a plurality of interconnect groups spaced by j groups to a same shift transmission circuit, where j=k-1, and k is the target quantity of the to-be-deployed shift transmission circuits.

Herein, in this embodiment of this application, the plurality of interconnects are arranged in a multi-row and multi-column matrix form. In some cases, the interconnects may be arranged in another form, but may be equivalently arranged in a matrix form based on a distance relationship between the interconnects.

For example, two shift transmission circuits need to be disposed for the semiconductor device, that is, k=2. When two shift transmission circuits are deployed, interconnect groups spaced by one group may be disposed in one shift transmission circuit. For example, refer to FIG. 17 and FIG. 21. If a connection line of interconnects is used as an identifier of an interconnect group, interconnect groups corresponding to L1, L3, L5, L7, L9, and L11 that are spaced by one interconnect group may be disposed in a same shift transmission circuit, and interconnect groups corresponding to L2, L4, L6, L8, L10, and L12 that are spaced by one interconnect group may be disposed in a same shift transmission circuit. In this way, two shift transmission circuits are formed, and any two adjacent interconnects are located in different shift transmission circuits.

If three shift transmission circuits need to be disposed for the semiconductor device, that is, k=3, when three shift transmission circuits are deployed, interconnect groups spaced by two groups may be disposed in one shift transmission circuit. For example, refer to FIG. 19 and FIG. 21. If a connection line of interconnects is used as an identifier of an interconnect group, interconnect groups corresponding to L1, L4, L7, and L10 that are spaced by two interconnect groups may be disposed in a same shift transmission circuit, interconnect groups corresponding to L2, L5, L8, and L11 that are spaced by two interconnect groups may be disposed in a same shift transmission circuit, and interconnect groups corresponding to L3, L6, L9, and L12 that are spaced by two interconnect groups may be disposed in a same shift transmission circuit. In this way, three shift transmission circuits are formed, and any two adjacent interconnects are located in different shift transmission circuits.

In this embodiment of this application, in consideration of impact of a signal transmission rate and costs, each shift transmission circuit may be the unidirectional shift transmission circuit shown in FIG. 6. In addition, the foregoing is merely an example description of automatically chaining shift transmission circuits. During chaining, if there is an interconnect corresponding to a signal that does not need to be chained in the shift transmission circuit, for example, a power supply signal, a clock signal, or a redundant signal, the interconnect only needs to be skipped.

An embodiment of this application further provides a computer storage medium. The computer storage medium stores computer instructions. When the computer instructions are run on an electronic device, the electronic device is enabled to perform the foregoing related method steps to implement the design method for a semiconductor device in the foregoing embodiments.

An embodiment of this application further provides a computer program product. When the computer program product runs on a computer, the computer is enabled to perform the foregoing related steps to implement the design method for a semiconductor device in the foregoing embodiments.

An embodiment of this application further provides a chip. The chip includes a substrate and the semiconductor device provided in the foregoing embodiments, and the semiconductor device is disposed on the substrate.

An embodiment of this application further provides an electronic device. The electronic device includes a circuit board and the foregoing chip, and the chip is electrically connected to the circuit board.

Based on the descriptions about the foregoing implementations, a person skilled in the art may understand that, for a purpose of convenient and brief description, division into the foregoing functional modules is used as an example for illustration. In actual application, the foregoing functions may be allocated to different functional modules and implemented based on requirements. In other words, an internal structure of an apparatus is divided into different functional modules to implement all or a part of the functions described above.

In the several embodiments provided in this application, it should be understood that the disclosed apparatus and method may be implemented in other manners. For example, the described apparatus embodiment is merely an example. For example, division into the modules or units is merely logical function division and may be other division during actual implementation. For example, a plurality of units or components may be combined or integrated into another apparatus, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate parts may or may not be physically separate, and parts displayed as units may be one or more physical units, may be located in one position, or may be distributed on different positions. A part or all of the units may be selected based on actual requirements to achieve the objectives of the solutions of embodiments.

In addition, functional units in embodiments of this application may be integrated into one processing unit, each of the units may exist alone physically, or two or more units may be integrated into one unit. The integrated unit may be implemented in a form of hardware, or may be implemented in a form of software functional unit.

When the integrated unit is implemented in the form of software functional unit and sold or used as an independent product, the integrated unit may be stored in a readable storage medium. Based on such an understanding, the technical solutions of this application essentially, or the part contributing to the conventional technology, or all or a part of the technical solutions may be implemented in a form of software product. The software product is stored in a storage medium and includes several instructions for instructing a device (which may be a single-chip microcomputer, a chip, or the like) or a processor (processor) to perform all or a part of the steps of the methods described in embodiments of this application. The storage medium includes various media that can store program code, such as a USB flash drive, a removable hard disk, a read-only memory (read-only memory, ROM), a random access memory (random access memory, RAM), a magnetic disk, or an optical disc.

The foregoing descriptions are merely specific implementations of this application, but are not intended to limit the protection scope of this application. Any variation or replacement readily figured out by a person skilled in the art in the technical scope disclosed in this application shall fall within the protection scope of this application. Therefore, the protection scope of this application shall be subject to the protection scope of the claims.

## Claims

1. A semiconductor device, comprising a first die, a second die, and a plurality of interconnects, wherein
the first die comprises a plurality of signal sending nodes and a plurality of shift sending circuits, the shift sending circuit comprises a plurality of signal input ends and a plurality of signal output ends, a signal input at an i^{th} signal input end is configured to be output from an i^{th} signal output end or an (i+1)^{th} signal output end, i is a positive integer, and the plurality of signal input ends of the shift sending circuit are separately connected to one signal sending node;
the second die comprises a plurality of signal receiving nodes and a plurality of shift receiving circuits, the shift receiving circuit comprises a plurality of signal input ends and a plurality of signal output ends, an i^{th} signal output end is configured to output a signal input at an i^{th} signal input end or an (i+1)^{th} signal input end, and the plurality of signal output ends of the shift receiving circuit are separately connected to one signal receiving node;
the i^{th} signal output end of the shift sending circuit is connected to the i^{th} signal input end of the shift receiving circuit through an i^{th} interconnect; and
any two adjacent interconnects of the semiconductor device are connected to different shift sending circuits, and the two adjacent interconnects are connected to different shift receiving circuits.

2. The semiconductor device according to claim 1, wherein different shift sending circuits have a same quantity of signal input ends or different quantities of signal input ends.

3. The semiconductor device according to claim 2, wherein the shift sending circuit comprises n signal input ends, n+1 signal output ends, and n-1 multiplexers, and the multiplexer comprises a first input end, a second input end, and an output end; and
in the shift sending circuit, a first input end of an m^{th} multiplexer is connected to an m^{th} signal input end of the shift sending circuit, a second input end of the m^{th} multiplexer is connected to an (m+1)^{th} signal input end of the shift sending circuit, and an output end of the m^{th} multiplexer is connected to an (m+1)^{th} signal output end of the shift sending circuit, wherein m and n are positive integers, and m≤n-1.

4. The semiconductor device according to claim 3, wherein a 1 ^{st} signal input end of the shift sending circuit is further connected to a 1^{st} signal output end of the shift sending circuit; and an n^{th} signal input end of the shift sending circuit is further connected to an (n+1)^{th} signal output end of the shift sending circuit.

5. The semiconductor device according to any one of claims 1 to 4, wherein different shift receiving circuits have a same quantity of signal input ends or different quantities of signal input ends.

6. The semiconductor device according to claim 5, wherein the shift receiving circuit comprises n+1 signal input ends, n signal output ends, and n multiplexers, and the multiplexer comprises a first input end, a second input end, and an output end; and
in the shift receiving circuit, a first input end of an m^{th} multiplexer is connected to an m^{th} signal input end of the shift receiving circuit, a second input end of the m^{th} multiplexer is connected to an (m+1)^{th} signal input end of the shift receiving circuit, and an output end of the m^{th} multiplexer is connected to an m^{th} signal output end of the shift receiving circuit, wherein m and n are positive integers, and m≤n-1.

7. The semiconductor device according to any one of claims 1 to 6, wherein the plurality of interconnects are arranged in rows and columns, and any two adjacent interconnects in a same row or a same column are connected to different shift sending circuits and different shift receiving circuits.

8. The semiconductor device according to any one of claims 1 to 7, wherein the interconnect comprises a micro bump, a hybrid bonding interconnect, and a through silicon via.

9. The semiconductor device according to any one of claims 1 to 8, wherein the plurality of interconnects comprise a first interconnect, a second interconnect, and a third interconnect, the first interconnect is adjacent to the second interconnect, a distance between the first interconnect and the second interconnect is less than or equal to a distance between the first interconnect and the third interconnect, and the distance between the first interconnect and the second interconnect is less than or equal to a distance between the second interconnect and the third interconnect.

10. A die, comprising a plurality of signal sending nodes, a plurality of shift sending circuits, and a plurality of interconnects, wherein
the shift sending circuit comprises a plurality of signal input ends and a plurality of signal output ends, a signal input at an i^{th} signal input end is configured to be output from an i^{th} signal output end or an (i+1)^{th} signal output end, and i is a positive integer;
the plurality of signal input ends of the shift sending circuit are separately connected to one signal sending node, and the plurality of signal output ends of the shift sending circuit are separately connected to one interconnect; and
any two adjacent interconnects of the die are connected to different shift sending circuits.

11. The die according to claim 10, wherein different shift sending circuits have a same quantity of input ends or different quantities of input ends.

12. The die according to claim 11, wherein the shift sending circuit comprises n signal input ends, n+1 signal output ends, and n-1 multiplexers, and the multiplexer comprises a first input end, a second input end, and an output end; and
in the shift sending circuit, a first input end of an m^{th} multiplexer is connected to an m^{th} signal input end of the shift sending circuit, a second input end of the m^{th} multiplexer is connected to an (m+1)^{th} signal input end of the shift sending circuit, and an output end of the m^{th} multiplexer is connected to an (m+1)^{th} signal output end of the shift sending circuit, wherein m and n are positive integers, and m≤n-1.

13. The die according to claim 12, wherein a 1^{st} signal input end of the shift sending circuit is further connected to a 1^{st} signal output end of the shift sending circuit; and
an n^{th} signal input end of the shift sending circuit is further connected to an (n+1)^{th} signal output end of the shift sending circuit.

14. A die, comprising a plurality of signal receiving nodes, a plurality of shift receiving circuits, and a plurality of interconnects, wherein the shift receiving circuit comprises a plurality of signal input ends and a plurality of signal output ends, an i^{th} signal output end is configured to output a signal input at an i^{th} signal input end or an (i+1)^{th} signal input end, and i is a positive integer;
the plurality of signal input ends of the shift receiving circuit are separately connected to one interconnect, and the plurality of signal output ends of the shift receiving circuit are separately connected to one signal receiving node; and
any two adjacent interconnects of the die are connected to different shift receiving circuits.

15. The die according to claim 14, wherein different shift receiving circuits have a same quantity of signal input ends or different quantities of signal input ends.

16. The die according to claim 15, wherein the shift receiving circuit comprises n+1 signal input ends, n signal output ends, and n multiplexers, and the multiplexer comprises a first input end, a second input end, and an output end; and
in the shift receiving circuit, a first input end of an m^{th} multiplexer is connected to an m^{th} signal input end of the shift receiving circuit, a second input end of the m^{th} multiplexer is connected to an (m+1)^{th} signal input end of the shift receiving circuit, and an output end of the m^{th} multiplexer is connected to an m^{th} signal output end of the shift receiving circuit, wherein m and n are positive integers, and m≤n-1.

17. A design method for a semiconductor device, wherein the method comprises:
obtaining a target quantity of to-be-deployed shift transmission circuits, wherein the target quantity is greater than or equal to 2; and
connecting a plurality of interconnects between a first die and a second die to a shift sending circuit of the first die and a shift receiving circuit of the second die, to form the target quantity of shift transmission circuits, wherein any two adjacent interconnects are located in different shift transmission circuits, the shift sending circuit comprises a plurality of signal input ends and a plurality of signal output ends, a signal input at an i ^{th} signal input end of the shift sending circuit is configured to be output from an i^{th} signal output end or an (i+1)^{th} signal output end of the shift sending circuit, the shift receiving circuit comprises a plurality of signal input ends and a plurality of signal output ends, an i^{th} signal output end of the shift receiving circuit is configured to output a signal input at an i^{th} signal input end or an (i+1)^{th} signal input end of the shift receiving circuit, the i^{th} signal output end of the shift sending circuit is connected to the i^{th} signal input end of the shift receiving circuit through an i^{th} interconnect, and i is a positive integer.

18. The method according to claim 17, wherein the plurality of interconnects between the first die and the second die are arranged in an interconnect array with a plurality of rows and a plurality of columns, and connecting the plurality of interconnects between the first die and the second die to the shift sending circuit of the first die and the shift receiving circuit of the second die, to form the target quantity of shift transmission circuits, wherein any two adjacent interconnects are located in different shift transmission circuits comprises:
dividing the interconnect array into a plurality of interconnect groups in a diagonal direction of the interconnect array, wherein connection lines of interconnects in each interconnect group are parallel to each other; and
connecting a plurality of interconnect groups spaced by j groups to a same shift transmission circuit, wherein j=k-1, and k is the target quantity of the to-be-deployed shift transmission circuits.

19. A computer-readable storage medium, wherein the computer-readable storage medium stores computer instructions, and when the computer instructions are executed, the steps of the method according to claim 17 or 18 are implemented.

20. A computer program product, wherein when the computer program product runs on a processor, the processor is enabled to perform the steps of the method according to claim 17 or 18.

21. A chip, wherein the chip comprises a substrate and the semiconductor device according to any one of claims 1 to 9, and the semiconductor device is disposed on the substrate.

22. An electronic device, wherein the electronic device comprises a circuit board and the chip according to claim 21, and the chip is electrically connected to the circuit board.
